# FASCICULE DE BREVET EUROPEEN

(11) **EP 1 192 637 B1**
(45) Date de publication et mention de la délivrance du brevet: **23.07.2008**
(21) Numéro de dépôt: 00949577.1
(22) Date de dépôt: 29.06.2000
(51) Int. Cl.: H01J 37/32, H05H 1/46, C01B 31/02

(54) **PROCEDE ET DISPOSITIF DE DEPOT PAR PLASMA A LA RESONANCE CYCLOTRON ELECTRONIQUE DE COUCHES DE TISSUS DE NANOFIBRES DE CARBONE ET COUCHES DE TISSUS AINSI OBTENUS**
VERFAHREN UND VORRICHTUNG ZUM EZR PLASMAAUFBRINGEN VON TEXTILIENSCHICHTEN AUS KOHLENSTOFF-NANOFASERN UND TEXTILIENSCHICHTEN DAZU
METHOD AND DEVICE FOR ELECTRONIC CYCLOTRONIC RESONANCE PLASMA DEPOSIT OF CARBON NANOFIBRE LAYERS IN FABRIC FORM AND RESULTING FABRIC LAYERS

(30) Priorité: 01.07.1999 FR 9908473
(43) Date de publication de la demande: 03.04.2002
(73) Titulaire: COMMISSARIAT A L'ENERGIE ATOMIQUE, 75015 Paris (FR)
(72) Inventeur: DELAUNAY, Marc, F-38240 Meylan (FR); SEMERIA, Marie-Noélle, F-38250 St Nizier du Moucherotte (FR)
(74) Mandataire: Audier, Philippe André
(86) Numéro de dépôt international: PCT/FR2000/001827
(87) Numéro de publication internationale: WO 2001/003158

(56) Documents cités:
- WO-A-97/20620
- DE-A- 19 740 389
- SUNG S L ET AL: "Well-aligned carbon nitride nanotubes synthesized in anodic alumina by electron cyclotron resonance chemical vapor deposition" APPLIED PHYSICS LETTERS, 11 JAN. 1999, AIP, USA, vol. 74, no. 2, pages 197-199, XP002136997 ISSN: 0003-6951
- THESS A ET AL: "Crystalline ropes of metallic carbon nanotubes" SCIENCE, 26 JULY 1996, AMERICAN ASSOC. ADV. SCI, USA, vol. 273, no. 5274, pages 483-487, XP002136998 ISSN: 0036-8075
- PATENT ABSTRACTS OF JAPAN vol. 1997, no. 11, 28 novembre 1997 (1997-11-28) & JP 09 188509 A (NEC CORP), 22 juillet 1997 (1997-07-22)
- PATENT ABSTRACTS OF JAPAN vol. 1998, no. 13, 30 novembre 1998 (1998-11-30) & JP 10 203810 A (CANON INC), 4 août 1998 (1998-08-04)
- DATABASE WPI Section Ch, Week 199506 Derwent Publications Ltd., London, GB; Class E36, AN 1995-041769 XP002136999 & JP 06 322615 A (NEC CORP), 22 novembre 1994 (1994-11-22)
- DATABASE WPI Section Ch, Week 199927 Derwent Publications Ltd., London, GB; Class E36, AN 1999-323246 XP002137000 & JP 11 116218 A (OSAKA GAS CO LTD), 27 avril 1999 (1999-04-27)
- PATENT ABSTRACTS OF JAPAN vol. 1999, no. 04, 30 avril 1999 (1999-04-30) & JP 11 011917 A (CANON INC), 19 janvier 1999 (1999-01-19)
- DATABASE WPI Section EI, Week 199935 Derwent Publications Ltd., London, GB; Class V05, AN 1999-409931 XP002137001 & JP 11 162383 A (ISE ELECTRONICS CORP), 18 juin 1999 (1999-06-18)

## Description

La présente invention concerne un procédé ainsi qu'un dispositif de dépôt par plasma à la résonance cyclotron électronique de couches de tissus de nanofibres de carbone.

L'invention concerne, en outre, les couches de tissus ainsi obtenus.

Le domaine technique de la demande peut être défini de manière générale, comme celui du dépôt de couches de carbone sur un substrat.

De telles couches sont notamment les couches de carbone émettrices d'électrons, mais on a également cherché à développer des procédés visant à synthétiser des couches de diamant et mettre à profit les propriétés mécaniques, optiques et électriques du diamant à des températures comprises généralement entre 400°C et 1 000°C, ou afin de réaliser des couches de carbone de type DLC (« Diamond Like Carbon » en anglais), généralement à basse température (20 à 400°C) et à fort taux de liaisons C-C sp₃, en particulier pour leurs propriétés mécaniques.

De telles couches sont principalement amorphes.

On s'intéresse plus précisément, dans la présente demande, à la préparation de couches de carbone formées de nanotubes ou de nanofibres.

Dans le tableau I, situé à la fin de la description, sont présentés différents dispositifs et procédés de dépôts sous vide de couches de carbone utilisés notamment pour le dépôt de carbone émissif.

Ce tableau met en évidence deux catégories de procédés de dépôts différents.

Il s'agit tout d'abord des procédés de dépôt chimique en phase vapeur CVD (« Chemical Vapour Deposition » en anglais), dans lesquels un gaz de molécules organiques (souvent du méthane) est introduit en mélange, avec ou sans hydrogène, dans un dispositif permettant de rompre les liaisons C-C, C-H et H-H par impact électronique avec, par exemple, l'utilisation d'un filament chaud, l'introduction d'une puissance micro-onde, l'utilisation d'une polarisation radiofréquence (RF) ou l'utilisation d'une résonance cyclotron électronique (RCE).

Suivant le dispositif utilisé, la pression de fonctionnement est forte (filament, micro-ondes, radiofréquence) ou faible (RCE, RF). Il en résulte une dissociation et une ionisation des particules d'autant plus importante que la pression est faible. L'énergie à fournir pour réaliser la réaction de transformation du gaz en solide est fortement diminuée par les ruptures de liaisons covalentes (par exemple CH₄) des molécules organiques.

Il est ainsi possible d'obtenir des structures cristallisées de type graphite ou diamant, à des températures de substrat plus faibles (par exemple 400°C au lieu de 800°C). La polarisation du substrat permet également de favoriser la cristallisation à plus basse température permettant l'utilisation d'une plus grande variété de substrats.

La seconde catégorie des procédés de dépôts regroupe les procédés, dits de dépôts physiques en phase vapeur, PVD (« Physical Vapour Deposition » en anglais), mettant en jeu un dépôt direct d'atomes ou d'ions de carbone, qui peut être effectué par pulvérisation d'une cible de graphite, par arc, par ablation laser, par faisceau d'ions ou par évaporation.

La qualité et la structure des couches dépendent essentiellement de l'énergie des ions ou des atomes de carbone incidents pour une température donnée.

Dans le cas de la préparation de couches de nanotubes ou nanofibres de carbone, qui nous préoccupe plus particulièrement, dans le cadre de la présente demande, on utilise également les procédés PVD et CVD, déjà décrits plus haut.

Ainsi, les documents [18] et [19] sont-ils relatifs à des procédés de production de nanotubes de carbone par des procédés PVD avec un apport direct en atomes de carbone C° par ablation laser ou arc électrique. Le document [18], décrit, plus précisément, un procédé de préparation de nanotubes de carbone utilisant une évaporation par arc entre deux électrodes de graphite dans l'hélium à haute pression (50 - 1 520 torrs). Des mélanges binaires de métaux du groupe du platine, tels que le rhodium et le platine sont utilisés comme catalyseurs.

Le document [19] a pour objet la synthèse de structures en carbone de type tubes ayant la forme d'épingles par évaporation par décharge à l'arc avec une électrode en carbone dans une enceinte remplie d'argon à 100 torrs.

Les nanotubes ou nanofibres peuvent également être préparés par des procédés CVD avec une déshydrogénation catalytique de molécules organiques, telles que l'acétylène ou le méthane.

Le dispositif utilisé peut mettre en oeuvre des filaments chauds, un système radiofréquence ou l'injection de micro-ondes à haute pression qui génère de l'hydrogène atomique et des radicaux ou ions, tels que CH₃⁺, CH₃° , CH° ,....

Toutefois, il est à noter que la réalisation d'architectures véritables organisées de nanofibres ou nanotubes de carbone et non de dépôts aléatoires et désorganisés de ceux-ci a été exploré jusqu'à présent.

Ainsi, le document [15] décrit-il la synthèse de nanotubes de carbone alignés utilisant un procédé basé sur le dépôt chimique en phase vapeur assisté par plasma PECVD (« Plasma Enhanced Chemical Vapour Deposition » en anglais) de carbone issu de la décomposition de l'acétylène d'un mélange gazeux acétylène-azote, le dépôt étant catalysé par des microparticules de fer emprisonnées dans la silice poreuse formant substrat.

Les images obtenues par microscopie électronique à balayage montrent que les nanotubes sont sensiblement perpendiculaires à la surface de la silice et forment des rangées de tubes isolés d'environ 50 micromètres de long et espacés d'environ 100 nanomètres.

Le document [16] décrit également la croissance de nanotubes de carbone orientés sur des substrats de nickel monocristallins et polycristallins par le procédé PECVD, en utilisant un filament chaud. Les nanotubes de carbone ont des diamètres de 10 à 500 nm et une longueur de 0,1 à 50 micromètres. De l'acétylène est utilisé comme source de carbone et de l'ammoniac est utilisé comme gaz de dilution et pour la catalyse.

Le document [17] est relatif à la croissance de films de nanotubes de carbone sur des substrats en silicium par CVD, à partir d'un mélange méthane-hydrogène, utilisant un plasma micro-ondes à une température de substrat de 900 à 1 000°C. Du fer ou du nickel est déposé, au préalable, sur le substrat pour servir de germe catalytique pour la croissance des nanotubes.

Tous les procédés, décrits ci-dessus, ne permettent pas de réaliser des architectures organisées de nanofibres ou nanotubes de carbone avec des liaisons fortes entré les tubes pour former une toile d'araignée (structure 2D).

On a vu que des alignements de nanofibres ou nanotubes pouvaient certes être obtenus, mais [15] [16] que, sans précautions particulières, les nanotubes de carbone se développaient [17] souvent de manière aléatoire, désorganisée, sous la forme d'amas de filaments ou de hérissons sans liaison C-C entre les tubes (structure 1D).

Si des tentatives, visant à améliorer des interconnexions, ont été effectuées [18] par l'ajout de nanograins de catalyseur, on obtient dans ce cas de nouveau qu'une architecture désordonnée et aléatoire sans liaison forte C-C entre les tubes.

En outre, aucun des procédés décrits ci-dessus ne permet de préparer des couches de nanotubes, et qui plus est, des architectures organisées de nanofibres ou nanotubes de carbone, telles que des tissus de nanofibres ou des nanotubes directement à partir de molécules organiques et sans catalyseur.

Enfin, aucun procédé n'autorise le dépôt de nanofibres ou de nanotubes sur une grande surface, c'est-à-dire généralement supérieure ou égale à 1 m².

Il existe donc un besoin pour un procédé de dépôt de tissus de nanofibres ou nanotubes de carbone, ne nécessitant pas de catalyseur, qui permette le dépôt de telles nano-architectures sur de grandes surfaces, à une température relativement basse.

Le but de la présente invention est donc de fournir un procédé de dépôt de tissus de nanofibres ou nanotubes de carbone qui réponde, entre autres, à l'ensemble des besoins mentionnés ci-dessus.

Le but de la présente invention est encore de fournir un procédé de dépôt de tissus de nanofibres ou nanotubes de carbone, qui ne présente pas les inconvénients, défauts, limitations, et désavantages des procédés de l'art antérieur et qui résolve les problèmes de l'art antérieur.

Ce but et d'autres encore sont atteints, conformément à la présente invention, par un procédé de dépôt par plasma à la résonance cyclotron électronique d'une couche d'un tissu de nanofibres ou nanotubes de carbone, ladite couche étant exempte de catalyseur, sur un substrat, en l'absence de catalyseur, par injection d'une puissance micro-ondes dans une chambre de dépôt comprenant une structure magnétique à miroir magnétique fortement déséquilibré, et au moins une zone de résonance cyclotron électronique à l'intérieur même de ladite chambre de dépôt et faisant face audit substrat, moyennant quoi on provoque, sous une pression inférieure à 10⁻⁴ mbar, l'ionisation et/ou la dissociation d'un gaz contenant du carbone dans ledit miroir magnétique au centre de la chambre de dépôt, en produisant ainsi des espèces qui vont se déposer sur ledit substrat, qui est chauffé.

De manière plus précise, ledit procédé comprend les étapes suivantes :
- chauffage du substrat ;
- établissement d'une pression inférieure ou égale à 10⁻⁴ mbar, de gaz contenant du carbone ;
- injection de la puissance micro-ondes, et création du plasma à partir dudit gaz contenant du carbone, pour une valeur au champ magnétique correspondant à la résonance cyclotron électronique ;
- création d'une différence de potentiel entre le plasma et le substrat ;
- dissociation et/ou ionisation des molécules dans ledit miroir magnétique au centre de la chambre de dépôt ;
- dépôt des espèces formées sur ledit substrat pour obtenir un tissu de nanofibres ou nanotubes de carbone.

Dans une forme de réalisation avantageuse du procédé selon l'invention, les étapes sont réalisées simultanément.

Le procédé selon l'invention se situe en fait entre les deux procédés extrêmes, d'une part, de dépôt physique en phase vapeur (PVD) et, d'autre part, de dépôt chimique en phase vapeur (CVD) et constitue un excellent compromis de ces deux techniques, sans en présenter aucun des inconvénients.

Le procédé selon l'invention répond aux besoins mentionnés ci-dessus et résout les problèmes des procédés de l'art antérieur, en particulier, contrairement aux procédés de dépôt de nanofibres ou nanotubes de l'art antérieur, le procédé selon l'invention qui met en oeuvre un plasma RCE particulier permet de réaliser des dépôts sur de très grandes surfaces supérieures, par exemple, à 1 m².

Dans le procédé de l'invention, on utilise, tout d'abord, une source de plasma RCE particulière, qui est une source confinente, à cause de la mise en oeuvre d'une structure magnétique à miroir magnétique fortement déséquilibré.

D'autre part, la zone de résonance cyclotron électronique RCE, au contraire de la plupart des procédés à plasma RCE [20], se trouve, selon l'invention, à l'intérieur même de la chambre de dépôt, face au substrat, et est ainsi intégrée à celle-ci, il n'y a donc pas de séparation entre la chambre de réaction du plasma RCE et la chambre de dépôt.

Ensuite, dans le procédé de l'invention, ladite source de plasma RCE, particulière et confinente, est mise en oeuvre à très basse pression, généralement inférieure à 10⁻⁴ mbar.

C'est essentiellement la combinaison de cette source de plasma RCE particulière et confinente avec cette très basse pression qui permet, selon l'invention, de dissocier fortement les molécules organiques pour obtenir des couches formées de tissus de nanofibres ou nanotubes de carbone, ou réseaux de nanofibres ou nanotubes de carbone interconnectées, comme dans une toile d'araignée.

Le plasma RCE créé selon l'invention, est un plasma stationnaire, stable, qui une fois installé, persiste et se stabilise. On obtient une dissociation complète des molécules allant jusqu'au terme des dissociations possible, par exemple, le méthane pourra se dissocier jusqu'à donner des espèces C°.

Plus précisément, on peut dire que c'est la durée de vie des particules du plasma qui augmente et non la durée de vie du plasma.

Autrement dit, ce confinement magnétique notable permet d'augmenter le temps de vie des ions et des électrons qui restent piégés dans le miroir magnétique au centre de la chambre de dépôt et le long des lignes de champ. Les taux de dissociation et d'ionisation des molécules dans le plasma sont donc ainsi augmentés avec des collisions électroniques du type :

CH₄ + e → CH₃⁺ + H° + e + e

CH₄ + e → CH₃° + H° + e

CH° + e → C° + H° + e, etc.

La faible pression augmente l'énergie des électrons et diminue les recombinaisons.

Le carbone déposé est généralement un carbone de type graphitique avec une proportion minoritaire de liaisons sp3 et majoritaire, par exemple, supérieure à 80 % de liaisons sp2.

De manière surprenante, selon l'invention, il a pu être constaté que pour une pression non conforme à l'invention, c'est-à-dire pour une pression supérieure à 10⁻⁴ mbar, il n'y a pratiquement pas de croissance de telles couches de carbone, mais, au contraire, l'apparition de grains de graphite ou de diamant de différentes dimensions avec parfois des morphologies de type choux-fleurs ou de amas de lave.

Des couches de fibres de carbone, ayant la structure décrite plus haut et sans catalyseur, n'ont jamais pu être obtenues par les procédés de l'art antérieur.

En outre et selon un avantage essentiel du procédé selon l'invention, les structures de couches tissées sont obtenues directement à partir d'un composé organique, sans qu'il soit besoin de recourir à un catalyseur, tel qu'un métal, par exemple, le nickel, le cobalt ou autre.

La structure magnétique à miroir magnétique fortement déséquilibré, selon l'invention, est telle que le champ magnétique est maximum (Bₘₐₓ) à l'injection micro-ondes, puis le champ magnétique est minimum (Bₘᵢₙ) au centre de la chambre de dépôt, et enfin le champ magnétique remonte sur le substrat (B_{substrat}).

En d'autres termes, on est en présence d'un miroir magnétique important, en amont, à l'injection et plus faible en aval, c'est-à-dire au niveau du substrat.

Avantageusement, selon l'invention, le rapport miroir en amont, à l'injection micro-ondes, défini par r₁ = Bₘₐₓ/Bₘᵢₙ est supérieur à 4.

Un tel rapport miroir élevé permet de faire diffuser les particules ionisées (ions et électrons) vers le substrat, sous l'effet d'un gradient descendant.

Avantageusement, le rapport miroir, en aval, vers le substrat, défini par r₂ = B_{substrat}/Bₘᵢₙ est supérieur ou égal à 1,5, par exemple égal à environ.1,5.

De préférence, selon l'invention, le substrat est chauffé à une température de 500°C à 750°C, de préférence de 550 à 700°C, pour fournir l'énergie d'activation nécessaire à la croissance.

Le chauffage du substrat peut être réalisé par bombardement électronique ou par chauffage externe, les électrons sont ceux du plasma, attirés par le substrat.

Le substrat peut être choisi parmi une grande variété de matériaux, dont la température de déformation est supérieure à la température de fonctionnement, comme, par exemple, le verre ou le silicium.

Le substrat n'a pas besoin d'être conducteur. De toute façon, c'est la couche de carbone conductrice qui s'établira au potentiel appliqué.

Selon l'invention, la pression est maintenue, de préférence, inférieure ou égale à 8.10⁻⁵ mbar, pour augmenter l'énergie des électrons et diminuer les recombinaisons.

Le gaz contenant du carbone peut contenir du carbone sous quelque forme que ce soit : toute molécule organique est acceptable.

Selon l'invention, le gaz contenant du carbone est, par exemple, le méthane, l'éthane, l'éthylène, l'acétylène et les mélanges, éventuellement additionnés d'hydrogène, en toute proportion.

Avantageusement, l'injection de la puissance micro-ondes a lieu à la fréquence de 2,45 GHz, pour une valeur de champ magnétique B, correspondant à la RCE, de l'ordre de 875 Gauss pour un gaz de type méthane.

Généralement, le substrat est polarisé positivement, par exemple, à de +20 volts à +100 volts, avec un flux d'électrons qui favorise la croissance sans catalyseur, conformément à l'invention, le plasma étant mis à la masse.

Une autre possibilité consiste à polariser, le plasma négativement, par exemple, à de -20 volts et -100 volts, le substrat étant mis à la masse.

L'invention a également trait à un dispositif de dépôt par plasma à la résonance cyclotron électronique de couches de tissus de nanofibres de carbone , lesdites couches étant exemptes de catalyseur sur un substrat exempt de catalyseur, ledit dispositif comprenant :
- une chambre de dépôt ;
- des moyens pour créer une structure magnétique à miroir magnétique fortement déséquilibré dans ladite chambre de dépôt ;
- une zone de résonance cyclotron électronique à l'intérieur même de ladite chambre de dépôt et faisant face audit substrat ;
- des moyens d'injection d'une puissance micro-ondes dans ladite chambre de dépôt ;
- des moyens pour créer une pression inférieure à 10-4 mbar d'un gaz contenant du carbone à l'intérieur de ladite chambre de dépôt.

Le dispositif selon l'invention peut comprendre, en outre, des moyens de chauffage du substrat, si le substrat n'est pas suffisamment chauffé par les électrons du plasma qui bombardent le substrat.

Le dispositif selon l'invention peut aussi comprendre, en outre, des moyens de création d'une différence de potentiel entre le plasma et le substrat.

Comme on l'a déjà indiqué, le dispositif selon l'invention se distingue des dispositifs de l'art antérieur à plasma RCE [20] essentiellement par le fait qu'il n'y a pas de séparation entre la chambre de création du plasma, la diffusion, et la chambre de dépôt, puisque la zone de RCE est intégrée à la chambre de dépôt.

L'invention concerne, en outre, une couche, éventuellement sur un substrat, formée d'un tissu ou réseau de nanofibres ou nanotubes de carbone interconnectés comme dans une toile d'araignée, ladite couche étant, en outre, exempte de catalyseur.

Une telle structure de couche tissée n'a jamais pu être obtenue par les procédés de l'art antérieur et peut être préparée pour la première fois par le procédé de l'invention sans catalyseur, du fait de la mise en oeuvre d'une source de plasma RCE particulière, confinente et à basse pression inférieure à 10⁻⁴ mbar.

En d'autres termes, selon l'invention, on prépare des mono-architectures de fibres ou de tubes de carbone, qui peuvent être définies comme des tissus (« nanotissus »).

Contrairement aux nanotubes créés à partir de nanograins catalytiques, notamment de métaux, tels que nickel, cobalt, etc., on obtient, selon l'invention, sans mettre en oeuvre aucun catalyseur et de manière surprenante, des réseaux de nanofibres de carbone interconnectés, comme dans une toile d'araignée.

La structure des couches selon l'invention est une structure fibreuse ordonnée et non pas aléatoire, et désordonnée, comme dans l'art antérieur, où les couches sont, en outre, polluées, contaminées par du catalyseur.

Par « exempte de catalyseur », on entend que les couches selon l'invention ne comprennent pas d'éléments pouvant être définis comme des catalyseurs, ces éléments étant essentiellement des métaux, comme le nickel, le cobalt, le fer, ou que ces éléments sont présents à l'état de trace ou d'impuretés habituelles.

De manière plus précise, les couches selon l'invention sont constituées de nanosegments de carbone liés entre eux par des liaisons fortes de carbone, ce qui constitue une morphologie différente des structures de nanotubes ou des nanofibres de carbone de l'art antérieur.

Selon l'invention, le carbone déposé est de type graphite avec une proportion minoritaire de liaisons sp3 et une proportion majoritaire, par exemple supérieure à 80 % de liaisons sp2.

Par « nano-architecture » ou « nanotissu », on entend généralement que le tissu ou réseau des couches selon l'invention a une dimension moyenne de maille de une ou quelques dizaines de nm à une ou quelques centaines de nm, par exemple de 20 à 200 nm.

De préférence, la dimension moyenne de maille est de 100 nm.

De même, par nanotubes ou nanofibres, on entend généralement que le diamètre de fibre ou de tube est de un ou quelques nm à une ou quelques dizaines de nm, par exemple, de 1 à 100 nm, de préférence de 20 nm.

La taille des mailles des tissus de fibre de carbone augmente lorsqu'on diminue la pression du gaz, tel que le méthane, par exemple de 8.10⁻⁵ à 6.10⁻⁵ mbar.

L'épaisseur des couches selon l'invention est généralement un ou quelques nm à une ou quelques dizaines de nm, par exemple, de 1 à 100 nm.

L'invention concerne également une structure à plusieurs couches (structure multicouche) comprenant au moins deux couches de tissu de nanofibres ou nanotubes de carbone selon l'invention, éventuellement sur un substrat.

Une telle structure pourra comprendre autant de couches qu'en exigera l'application, et aura une épaisseur généralement de une ou quelques dizaines de nm à une ou quelques centaines de nm, par exemple, de 2 à 200 nm.

Le substrat sur lequel se trouve la couche ou la structure multicouche décrite plus haut peut être choisi parmi tous les substrats, déjà mentionnés plus haut, il pourra s'agir, par exemple, de verre, tel que du verre borosilicate ou de silicium.

On notera que par extension, les couches ou structures selon l'invention pourraient aussi être désignées par la dénomination de « tissus ».

Les couches selon l'invention formées d'un tissu ou réseau de nanofibres de carbone, outre leur structure spécifique possédent un certain nombre de propriétés excellentes, qui les rendent particulièrement adéquates à un grand nombre d'applications.

Le tissu ou fibre de carbone selon l'invention est conducteur électrique et réfractaire, comme le graphite.

Ainsi, il possède une tenue en température qui est généralement supérieure à 700°C.

En outre, la résistance mécanique de ces couches est excellente et ces couches sont émettrices d'électrons par effet de champ, à un champ seuil de 10 à 20 V/µm.

De plus, les couches sont inertes chimiquement à la température ambiante, comme le graphite.

Enfin, on peut réaliser pour la première fois, selon l'invention, des couches ou structures multicouches de grande surface, par exemple, de 0,25 m² à 1 m² et sans catalyseur.

Les propriétés décrites ci-dessus sont mises à profit dans les nombreuses applications possibles des couches et des structures multicouches selon l'invention formées d'un tissu ou réseau de nanofibres ou nanotubes de carbone interconnectées, comme dans une toile d'araignée.

L'invention concerne ainsi un filtre, en particulier un filtre bactérien ou un filtre à virus comprenant au moins une desdites couches ou lesdites structures multicouches, éventuellement sur un substrat ou sur une grille.

En effet, la dimension moyenne des mailles des tissus de nanofibres de carbone selon l'invention correspondent aux meilleurs filtres bactériens connus. On se reportera, à ce propos, à l'ouvrage de G. LEYRAL, J. FIGARELLA et M. TERRET, Microbiologie appliquée, tome 2, Editions J. LANORE, p. 150 (liquides) et p. 174 (gaz).

En particulier, dans le cas des liquides, on peut réaliser des filtres permettant la filtration stérilisante de particules et de bactéries dont la taille est supérieure à 0,2 µm, 0,2 µm correspondant à la taille des plus petites bactéries.

Les filtres selon l'invention seront donc définis comme des filtres bactériens. Pour certaines couches, les filtres selon l'invention pourront permettre la filtration de virus.

Les couches ou structures multicouches selon l'invention peuvent, de manière avantageuse, présenter une surface importante. Cette propriété est particulièrement mise en profit dans le cadre de la filtration où l'on doit disposer de surfaces filtrantes de grande dimension.

Dans les filtres selon l'invention, la couche ou structure multicouche est étalée sur un grillage rigide, par exemple métallique, à plus grandes mailles, par exemple de quelques centaines de µm, afin de permettre la filtration.

L'invention concerne également les nanogrilles accélératrices ou décélératrices d'électrons comprenant au moins une couche ou au moins une structure multicouche selon l'invention. On exploite, dans de telles nanogrilles, les propriétés conductrices et réfractaires des couches selon l'invention.

L'invention concerne, en outre, un écran plat, en particulier, un écran plat de grandes dimensions, qui comprend au moins une couche ou au moins une structure multicouche selon l'invention, éventuellement sur un substrat. On exploite ainsi le fait que ces couches ou structures sont émettrices d'électrons par effet de champ et peuvent ainsi avantageusement remplacer les micro-pointes métalliques actuellement utilisés dans les écrans plats.

Les applications, données ci-dessus, ne sont que quelques exemples des applications des couches et structures selon l'invention qui peuvent trouver leur application dans tous les domaines ou leurs propriétés, en particulier leur résistance mécanique peuvent être mises à profit.

### Brève description des dessins

La figure 1 illustre une source à plasma à résonance cyclotron électronique à bobines rectangulaires pour la mise en oeuvre du procédé selon l'invention, le substrat étant avantageusement en défilement suivant une dimension.
La figure 2 montre le profil du champ magnétique axial de la source de plasma.
Les figures 3A et 3B sont des photographies au microscope électronique à balayage (MEB) de multicouches de tissus de nanofibres de carbone déposées sur un substrat en silicium, par le procédé selon l'invention. Une graduation représente 1 µm.
Les figures 4A et 4B sont des photographies au microscope électronique à balayage (MEB) de multicouches de tissus de nanofibres de carbone déposées sur un substrat en verre borosilicate, par le procédé selon l'invention. Une graduation représente 1 µm.
La figure 5 est une photographie au microscope électronique en transmission (MET) d'une monocouche de nanofibres de carbone déposées sur un substrat en verre borosilicate par le procédé selon l'invention. Une graduation représente 100 nm.

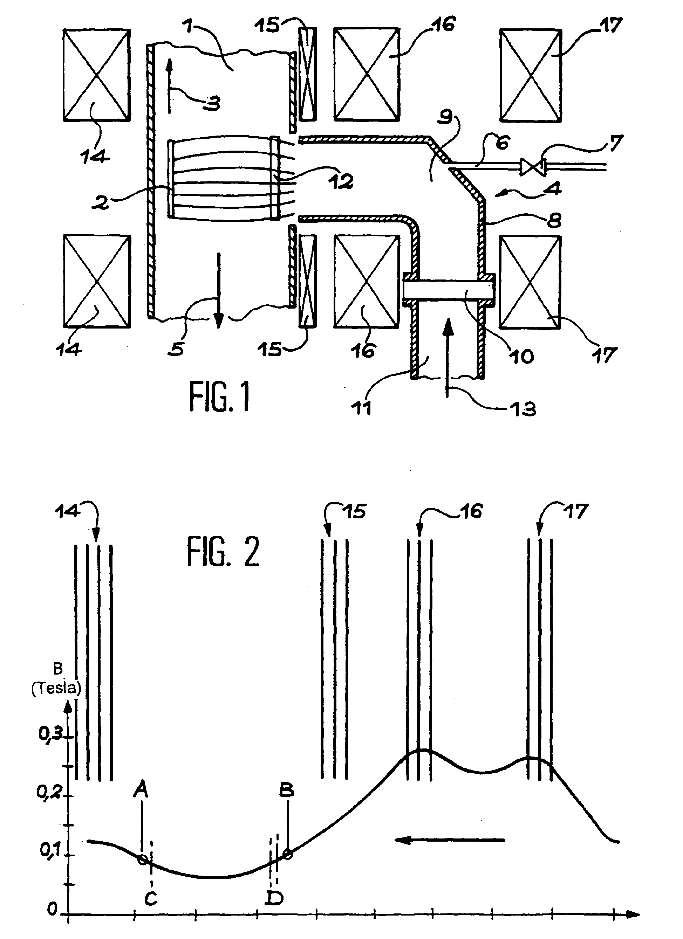

De manière plus détaillée, le procédé selon l'invention peut être mis en oeuvre, par exemple, avec le dispositif, tel que celui qui est décrit sur la figure 1.

Ce dispositif comprend essentiellement une chambre de dépôt (1), dans laquelle on trouve un substrat (2).

Ce substrat (2) peut être animé, par exemple, d'un déplacement rectiligne (3) de translation. Le substrat (2) peut être polarisé, négativement, positivement, ou mis à la masse.

De préférence, le substrat est polarisé positivement, généralement à de +20 à +100 volts, une telle polarisation positive permet de compléter la dissociation des molécules organiques sur le substrat.

Le substrat a généralement une forme plane et une taille de 0,25 m² à 1 m², c'est là, on l'a vu, un des avantages de l'invention que de permettre le dépôt de couches de fibres de carbone sur des surfaces relativement grandes, par exemple, de la taille du substrat de 0,25 à 1 m², et plus, ce qui est particulièrement intéressant pour la réalisation d'écrans plats de grande surface. Le substrat est, par exemple, en verre, comme un verre de type borosilicate, ou en silicium.

Le substrat sur lequel sont déposées les couches de fibre de carbone peut être, aussi, de préférence, réalisé en un matériau susceptible d'être dissout dans une opération suivant l'opération de dépôt, les couches de fibre de carbone, ainsi séparées du substrat initial, sont ensuite étalées sur un grillage rigide, par exemple, à plus grandes mailles, par exemple, en métal ou alliage, tel que le tungstène, ou l'acier inoxydable, dans le cas où le tissu en fibres de carbone doit être utilisé comme filtre bactérien.

La chambre ou enceinte de dépôt (1) reçoit la puissance générée par un ou plusieurs émetteurs micro-ondes (flèche 13), par l'intermédiaire d'un coupleur (4) qui répartit cette puissance dans la chambre ou enceinte de dépôt.

Cette injection de puissance micro-ondes dans l'enceinte produit l'ionisation d'un gaz sous faible pression contenant du carbone.

Selon l'invention, cette pression est une faible pression, à savoir, comme on l'a déjà indiqué plus haut, une pression inférieure à 10⁻⁴ mbar, de préférence à 8.10⁻⁵ mbar.

La faible pression à l'intérieur de l'enceinte ou chambre de dépôt est maintenue par l'intermédiaire d'un pompage, représenté par la flèche (5).

Le gaz contenant du carbone est, quant à lui, introduit en amont, dans le coupleur, par exemple par une canalisation (6) munie d'une vanne de régulation (7).

Le gaz est choisi, par exemple, parmi le méthane, l'éthane, l'éthylène, l'acétylène et leurs mélanges, éventuellement additionné d'hydrogène.

Le coupleur (4) comprend un guide d'injection micro-ondes (8) se terminant par un coude (9), faisant un angle de 90°, qui est connecté à la chambre ou enceinte de dépôt (1) perpendiculairement à celle-ci.

Une fenêtre d'étanchéité (10) aux micro-ondes, par exemple, en quartz, est disposée dans le guide d'onde entre le guide d'onde d'admission (11) et ledit coude à 90° (9).

Cette fenêtre d'étanchéité assure la séparation entre le guide d'admission, ou d'injection (11) dans laquelle se trouve de l'air à la pression atmosphérique et le coude, ainsi que l'enceinte ou chambre de dépôt qui sont sous vide, grâce au pompage.

Du fait de la configuration décrite ci-dessus, l'injection micro-ondes et la fenêtre d'étanchéité (10) sont situées à 90° de l'axe du dispositif, ce qui permet d'éviter que la fenêtre d'étanchéité ne soit recouverte par du carbone et assure un fonctionnement continu du dispositif.

Conformément à l'invention, la zone de résonance cyclotron électronique, représentée par la référence (12) figure 1, se trouve à l'intérieur même de la chambre ou enceinte de dépôt et fait face au substrat.

De ce fait, il n'y a pas, dans le dispositif de l'invention, de séparation entre la chambre de création du plasma (RCE), la diffusion et la chambre de dépôt, puisque, selon l'invention, la zone de RCE est intégrée à la chambre de dépôt.

Selon l'invention, la puissance micro-ondes est injectée dans une structure magnétique spécifique à miroir magnétique fortement déséquilibré et comprenant la zone de résonance cyclotron électronique (12), positionnée comme indiqué ci-dessus, à l'intérieur même de la chambre de dépôt (1), ce qui provoque une dissociation et/ou une ionisation des molécules composant le gaz contenant du carbone, en produisant des espèces qui vont se déposer sur ledit substrat.

Le champ magnétique de résonance cyclotron électronique (RCE) peut être produit par des enroulements de conducteurs, tels que bobines ou solénoïdes de géométrie rectangulaire, carrée ou cylindrique ou par des aimants permanents.

Sur la figure 1, les bobines de champ magnétique sont des bobines de champ magnétique rectangulaires (14, 15, 16, 17).

Les dimensions du dépôt dépendent principalement de la surface du champ magnétique de résonance cyclotron électronique (RCE) créé. Dans le cas des bobines de champ magnétique rectangulaires (14, 15, 16, 17), illustrées sur la figure 1, on peut, par exemple, obtenir une hauteur de plasma de 25 cm, qui peut être étendu à 1 mètre.

Selon l'invention, le champ magnétique créé présente un profil particulier, formant une structure magnétique à miroir magnétique fortement déséquilibré. Ainsi, le profil du champ magnétique axial créé dans le dispositif de la figure 1 est-il représenté sur la figure 2 qui donne la valeur du champ magnétique axial B (en Tesla) en divers points situés sur l'axe de l'appareil de dépôt, en abscisse se trouve une échelle de longueur, chaque graduation, représentant 10 cm.

Sur cette figure, les ensembles de traits verticaux en haut du graphique représentent les positions des bobines de champ magnétique rectangulaires (14, 15, 16 et 17) respectivement alimentées par des courants de 370A, 370A, 900A et 900A.

En effet, selon l'invention, c'est le profil du champ qui est important. Pour cela, on alimente les bobines avec des courants pour obtenir les champs adéquats. Par exemple, les bobines 14 et 15 sont alimentées avec 370 A pour donner un champ B = 600 G ; et les bobines 16 et 17 sont alimentées avec 900 A pour donner un champ B = 2 700 G.

Dans ce cas, les rapports désirés donnés ci-dessus, à savoir r₁ > 4 et r₂ ≥ 1,5 sont bien vérifiés.

Sur la courbe représentant le champ magnétique axial, on a indiqué les positions de la chambre de dépôt qui se situe entre les points A et B, la position du substrat (point C), ainsi que la position de la zone de résonance cyclotron électronique (RCE) représentée par la segment D. La flèche indique la direction de l'injection micro-ondes et de l'injection de gaz.

On constate que le champ magnétique est maximum et élevé à l'injection micro-ondes, où il a une valeur, par exemple, de 2 700 G, le champ magnétique présente un minimum, par exemple, de 600 G au centre de la chambre de dépôt, puis le champ magnétique remonte sur le substrat.

On a donc un miroir magnétique important à l'injection et plus faible en aval.

Typiquement, le rapport miroir à l'injection r₁ est supérieur à 4.

Ainsi, dans le cas du dispositif de la figure 1, r₁ = Bₘₐₓ/Bₘᵢₙ = 2 700 G/600 G = 4,5.

Ce rapport miroir r₁ élevé permet de faire diffuser les particules ionisées, ions et électrons, vers le substrat, sous l'effet d'un gradient descendant.

Typiquement, le rapport miroir r₂ en aval, vers le substrat, est au minimum de 1,5.

Ainsi, dans le cas du dispositif de la figure 1, r₂ = B_{substrat}/Bₘᵢₙ = 900 G/600 G = 1,5.

Comme on l'a déjà indiqué plus haut, le confinement magnétique notable, selon l'invention, permet d'augmenter le temps de vie des ions et des électrons qui restent piégés dans le miroir magnétique au centre de la chambre de dépôt et le long des lignes de champ.

Les taux de dissociation et d'ionisation des molécules dans le plasma sont donc ainsi augmentés avec des collisions électroniques du type :

CH₄ + e → CH₃⁺ + H° + e + e

CH₄ + e → CH₃° + H° + e

CH° + e → C° + H° + e, etc.

L'invention va maintenant être décrite, en référence aux exemples suivants, donnés à titre illustratif et non limitatif.

### Exemples

On effectue, selon l'invention, sur différents substrats et sans catalyseur, le dépôt de nanotissus de fibres ou tubes de carbone. Le dispositif mis en oeuvre est sensiblement analogue à celui de la figure 1.

### Exemple 1

Dans cet exemple, le gaz utilisé est du méthane et le substrat est du silicium chauffé à 640°C.

La pression à l'intérieur de la chambre ou enceinte de dépôt est de 6.10⁻⁵ mbar.

On obtient ainsi des multicouches d'un tissu ou réseau de nanofibres ou nanotubes de carbone d'un diamètre de fibre d'environ 20 nm interconnectés comme dans une toile d'araignée dont la dimension moyenne de maille est inférieure à 200 nm.

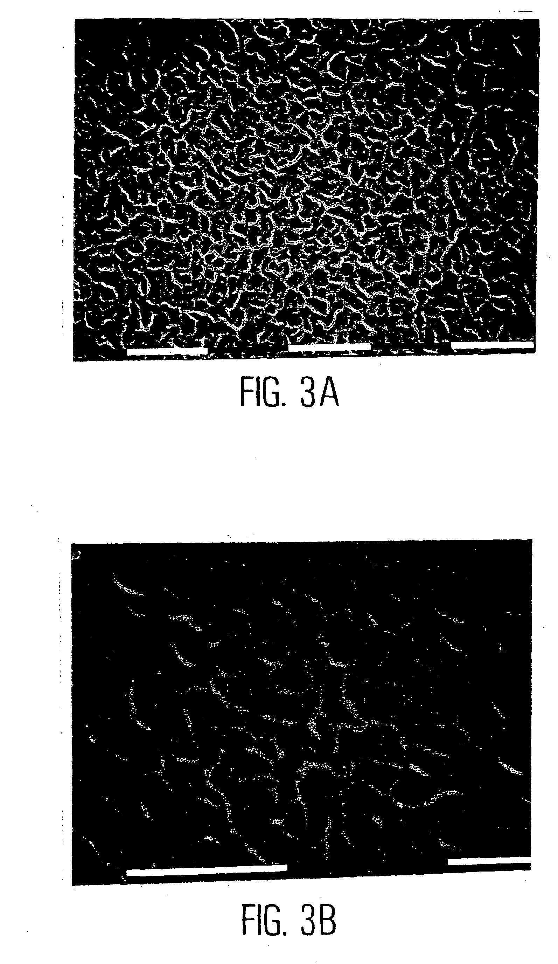

Les figures 3A et 3B sont les photographies de telles multicouches, observées au microscope électronique à balayage (MEB).

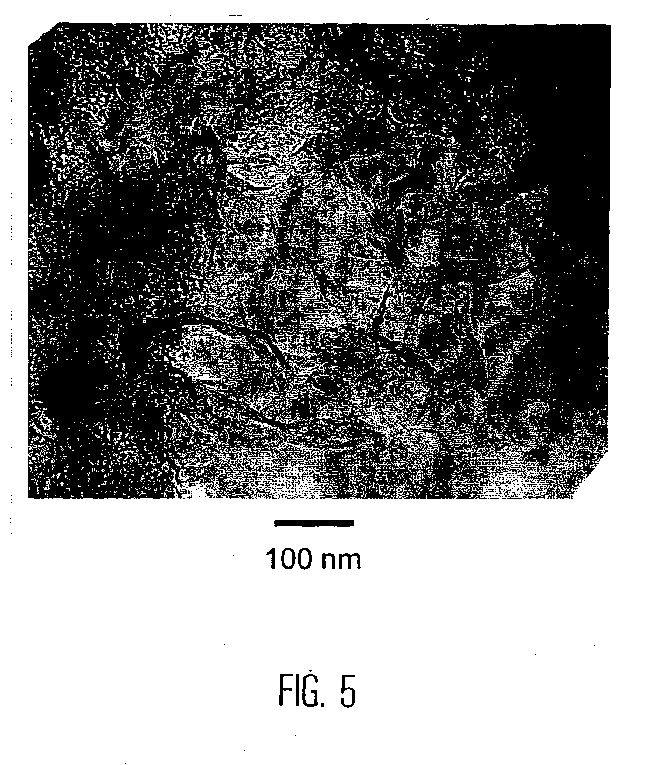

On a également arraché une couche (monocouche) du dépôt multicouches et on l'a étalée sur la grille d'un microscope électronique en transmission (MET) : une telle manipulation met en évidence la solidité des couches obtenues par le procédé de l'invention. La photographie de la monocouche, observée au MET, est présentée sur la figure 5.

### Exemple 2

Dans cet exemple, le gaz utilisé est du méthane et le substrat est du verre borosilicate chauffé à 680°C.

La pression à l'intérieur de la chambre ou enceinte de dépôt est de 8.10⁻⁵ mbar.

On obtient ainsi, de la même manière que dans l'exemple 1, des multicouches d'un tissu ou réseau de nanofibres ou nanotubes de carbone interconnectés comme dans une toile d'araignée, d'un diamètre de fibre d'environ 20 nm, dont la dimension moyenne de maille est voisine ou inférieure à 100 nm.

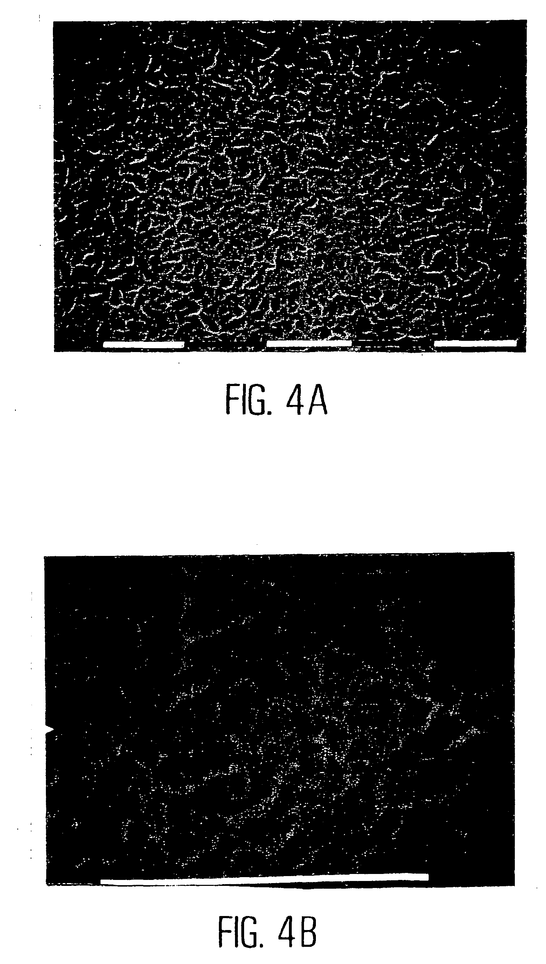

Les figures 4A et 4B sont les photographies de telles multicouches, observées au microscope électronique à balayage (MEB).

Outre ces analyses par MEB et éventuellement MET, d'autres analyses ont également été effectuées. Les résultats de l'ensemble des analyses effectuées sur les multicouches et monocouches des exemples 1 et 2 sont les suivantes :
- composition : carbone (quelques % d'hydrogène ont été identifiés) (déterminée par E. R. D. A. = Elastic Recoil Detection Analysis) ;
- MET : clichés de diffraction : distance d(hkl) observée est de 3.47 A, qui correspond plus à une structure de type nanotubes (d = 3.44 A), qu'à des cristaux de graphite plans (d = 3.35 A).

Il est à noter que les nanotubes sont des feuillets enroulés et concentriques avec des cycles hexagonaux de carbone, comme dans le graphite (dont les feuillets restent plans).
- MEB : multicouches du nanotissu avec un diamètre de fibre d'environ 20 nm (voir les figures 3A, 3B, 4A, 4B) ;
- XPS (Spectrophotométrie X) : environ 80 % de liaison sp2 (graphitique plan ou enroulé) ;
- matériau bon conducteur électrique comme le graphite ;
- analyse aux RX : structure graphitique ;
- spectroscopie Raman (méthode optique avec laser) : structure graphitique ;
- tenue en température : supérieure à 700°C ;
- inertie chimique à la température ambiante : comme le graphite.

**Tableau I**

| Exemples de dépôts de couches de carbone | | | | | | | | |
|---|---|---|---|---|---|---|---|---|
| | Dispositif | Réf. | Procédé | Tempér. Substrat (°C) | Pression (mbar) | % gaz | Champ Seuil Emission (V/µm) | Polaris. Substrat (V) |
| D I A M A N T | filament chaud | [1] | GVD (ou « Chemical Vapour Deposition ») | 800 à 1 000 | 30 à 50 | 1 % CH₄/H₂ | 20 | |
| | micro-ondes | [2] | CVD | 800 | | 1 % CH₄ C₂H₅OH | 22 à 50 | |
| | micro-ondes | [3] | CVD | 650 à 1 100 | 20 à 100 | 0,5 à 3 % CH₄ | | 0à-300 |
| | RCE | [4] | CVD | 300 à 500 | 2 x 10⁻² à 2 | CH₃OH ou 0,5 % CH₄ | | +30 |
| | RF (ou radio-fréquence) | [5] | CVD | 700 à 1 200 | 20 à 30 | 0,2 à 1 % CH₄/H2 | | |
| D L C « D i a m o n d L i k e C a r b o n » | arc | [6] | ions C⁺ | 20 | P↓ | sans | 10 | 0à-350 |
| | RF | [7] | PECVD | 20 | 10⁻³ à 3 x 10 | CH₄ ou 10% CH₄ avec He | 5 à 20 | -100 |
| | source d'ions | [8] | pulvérisation de carbone par ions CO⁺ | 20 | | | 17 | |
| | laser | [9] | ablation → plasma de carbone | 20 | | | 10 | |
| | RCE | [10] | CVD | 20 à 100 | 10⁻³ à 10⁻² | 20 % à 100 % CH₄ | | -50 à -500 |
| G R A P H I T E | RCE | [11] | CVD | 400 à 600 | 6 x 10⁻⁴ | CH₄ 10-50 % H₂ | 10 à 30 | +100 |
| | micro-ondes | [12] | CVD | 800 | 40 | 1 % CH₄ 99 % H₂ | 5 | |
| | suie | [13] | collage suie | 20 | | | 20 | |
| | décharge électrique | [14] | CVD nanotubes | 900 | | CH₄ | | |

### REFERENCES

[1] « Field Emission From P-Type Polycrystalline Diamond Films » de D. Hong et M. Aslam (Revue « Le Vide, les Couches Minces », Supplément au N° 271, Mars-avril 1994, pages 96 à 99)
[2] « Defect-Enhanced Electron Field Emission From Chemical Vapor Deposited Diamond » de W. Zhu, G.P. Kochanski, S. Jin et L. Seibles (Journal Applied Physics, 78(4), 15 août 1995, pages 270 et suivantes)
[3] « High-Sensitivity Absorption Spectroscopy On A Microwave Plasma-Assisted Chemical Vapour Deposition Diamond Growth Facility » de C.J. Erickson, W.B. Jameson, J. Watts-Cain, K.L. Menningen, M.A. Childs, L.W. Anderson et J.E. Lawler (Plasma Sources Sci. Technol. 5 (1996), pages 761-764)
[4] « Fabrication of Diamond Films at Low Pressure and Low-Temperature by Magneto-Active Microwave Plasma Chemical Vapor Deposition » de Takuya Yara, Motokazu Yuasa, Manabu Shimizu, Hiroshi Makita, Akimitsu Hatta, Jun-Ichi Suzuki, Toshimichi Ito et Akio Hiraki (pn. J. Appl. Phys., Vol. 33 (1994), pages 4404-4408, art 1, No. 7B, Juillet 1994)
[5] « Chemical Vapour Deposition Of Diamond in RF Glow Discharge » de Seiichiro Matsumoto (Journal of Materials Science Letters 4 (1985), pages 600-602)
[6] « Field Emission From Tetrahedral Amorphous Carbon » de B.S. Satyanarayana, A. Hart, W.I. Milne et J. Robertson (Appl. Phys. Lett. 71 (10), 8 septembre 1997, pages 1 à 3)
[7] "Nitrogen Containing Hydrogenated Amorphous Carbon For Thin-Film Field Emission Cathodes » de Gehan A. J. Amaratunga et S.R.P. Silva (Appl. Phys. Lett. 68 (18), 29 avril 1996, pages 2529 à 2531)
[8] « Electron Field Emission From Amorphous Carbon-Cesium Alloys » de S.P Bozeman, S.M. Camphausen, J.J. Cuomo, S.I. Kim, Y.O. Ahn et Young Ko (J. Vac. Sci. Technol. A 15(3), mai/juin 1997, pages 1729 à 1732)
[9] « Electron Field Emission From Amorphous Tetrahedrally Bonded Carbon Films » de A.A. Talin, T.E. Felter, T.A. Friedmann, J.P. Sullivan et M.P. Siegal (J. Vac. Sci. Technol. A 14(3), mai/juin 1996, pages 1719 à 1722)
[10] « High Quality Diamond Like Carbon Thin Film Fabricated by ECR Plasma CVD » de K. Kuramoto, Y. Domoto, H. Hirano, S. Kiyama et S. Tsuda (Applied Surface Science 113/114 (1997), pages 227-230)
[11] « ECR Plasma Ion Source For Material Depositions » de M. Delaunay et E. Touchais (Rev. Of Sci. Instrum. Février 1998, n° A97622)
[12] « Field Electron Emission From Highly Graphitic Diamond Film With Ball-Like Surface Morphologies » de Li Yunjun, He Jintian, Yao Ning et Zhang Binglin (Technical Digest of IVMC'97, Kyongju, Corée, 1997)
[13] « Flat Panel Displays Based Upon Low-Voltage Carbon Field Emitters » de A.Y. Tcherepanov, A.G. Chakhovskoi et V.V. Sharov (« Le Vide, les Couches Minces », supplément au N° 271, mars-avril 1994).
[14] « La télévision du futur se met à plat » de Jean-Michel Le Corfec (« Sciences et avenir », avril 1998, page 87).
[15] « Large-Scale Synthesis of Aligned Carbon Nanotubes » de W. Z. Li, S. S. Xie, L. X. Qian, B. H. Chang, B. S. Zou, W. Y. Zhou, R. A. Zhao, G. Wang (Science, vol. 274, 6 Décembre 1996, pages 1 701 à 1 703).
[16] « Growth of Highly oriented Carbon nanotubes by plasma-enhanced hot filament chemical vapour deposition », de Z. P. Huang, J. W. Xu, Z. F. Ren, J. H. Wang, M. P. Siegal, P. N. Provencio (Applied Physics Letters, vol. 73, numéro 26, 28 décembre 1998, pages 3 845 à 3 847).
[17] « Electron Field emission from phase pure nanotube films grown in a methane/hydrogen plasma », de O. M. Küttel, O. Groening, Ch. Emmenegger, L. Schlapbuch (Applied Physics Letters, vol. 73, numéro 15, 12 octobre 1998, pages 2 113 à 2 115).
[18] « High yield of single-wall carbon nanotubes by arc discharge using Rh-Pt mixed catalysts », de Y. Saito, Y. Tani, N. Miyagawa, K. Mitsushima, A. Kabuya, Y. Nishina (Chemical Physics Letters 294 (1998), pages 593 - 598).
[19] « Helical microtubes of graphitic carbon » de S. Iijima (Nature, vol. 354, 7 novembre 1991) pages 56 à 58).
[20] « Electron cyclotron resonance plasma in source for material depositions » de M. Delaunay et E. Touchais (Review of Scientific Instruments, vol. 69, numéro 6, Juin 1998, pages 2 320 à 2 324).

## Revendications

1. Procédé de dépôt par plasma à la résonance cyclotron électronique d'une couche d'un tissu de nanofibres ou nanotubes de carbone, ladite couche étant exempte de catalyseur, sur un substrat exempt de catalyseur, par injection d'une puissance micro-ondes dans une chambre de dépôt comprenant une structure magnétique à miroir magnétique fortement déséquilibré, et au moins une zone de résonance cyclotron électronique à l'intérieur même de ladite chambre de dépôt et faisant face audit substrat, moyennant quoi on provoque, sous une pression inférieure à 10⁻⁴ mbar, l'ionisation et/ou la dissociation d'un gaz contenant du carbone dans ledit miroir magnétique au centre de la chambre de dépôt, en produisant ainsi des espèces qui vont se déposer sur ledit substrat qui est chauffé.

2. Procédé selon la revendication 1, comprenant les étapes suivantes :
- chauffage du substrat ;
- établissement d'une pression inférieure ou égale à 10⁻⁴ mbar, de gaz contenant du carbone ;
- injection de la puissance micro-ondes, et création du plasma à partir dudit gaz contenant du carbone, pour une valeur du champ magnétique correspondant à la résonance cyclotron électronique ;
- création d'une différence de potentiel entre le plasma et le substrat ;
- dissociation et/ou ionisation des molécules dans ledit miroir magnétique au centre de la chambre de dépôt ;
- dépôt des espèces formées sur ledit substrat pour obtenir un tissu de nanofibres ou nanotubes de carbone.

3. Procédé salon la revendication 2, dans lequel les étapes sont réalisées simultanément.

4. Procédé selon l'une quelconque des revendications 1 à 3, dans lequel le carbone déposé est de type graphite avec une proportion minoritaire de liaisons sp3 et une proportion majoritaire de liaisons sp2.

5. Procédé selon la revendication 1, dans lequel ladite structure du miroir magnétique est telle que le champ magnétique est maximum (Bₘₐₓ) à l'injection micro-ondes, puis le champ magnétique est minimum (Bₘᵢₙ) au centre de la chambre de dépôt et enfin le champ magnétique remonte sur le substrat (B_{substrat}).

6. Procédé selon la revendication 1, dans lequel le rapport miroir en amont à l'injection micro-ondes, défini par r₁ = Bₘₐₓ (en Gauss) /Bₘᵢₙ (en Gauss) est supérieur à 4.

7. Procédé selon l'une quelconque des revendications 1 à 6, dans lequel le rapport miroir, en aval, vers le substrat, défini par r₂ = B_{substrat} (en Gauss)/Bₘᵢₙ est supérieur ou égal à 1,5.

8. Procédé selon l'une quelconque des revendications 1 à 7, dans lequel le substrat est chauffé à une température de 500 à 750°C.

9. Procédé selon l'une quelconque des revendications 1 à 8, dans lequel la pression est inférieure ou égale à 8.10⁻⁵ mbar.

10. Procédé selon l'une quelconque des revendications 1 à 9, dans lequel ledit gaz contenant du carbone est choisi parmi le méthane, l'éthane, l'éthylène, l'acétylène, et leurs mélanges, éventuellement additionné d'hydrogène.

11. Procédé selon la revendication 1, dans lequel le chauffage du substrat est réalisé par bombardement électronique ou par chauffage externe.

12. Procédé selon la revendication 1, dans lequel l'injection de la puissance micro-onde a lieu à la fréquence de 2,45 GHz.

13. Procédé selon la revendication 1, dans lequel le substrat est polarisé positivement, par exemple, à de +20 volts +100 volts, et le plasma est mis à la masse.

14. Procédé selon la revendication 1, dans lequel le plasma est polarisé négativement, par exemple, à de -20 volts à -100 volts et le substrat est mis à la masse.

15. Dispositif de dépôt par plasma à la résonance cyclotron électronique (RCE) de couches de tissus de nanofibres de carbone, lesdites couches étant exemptes de catalyseur, sur un substrat exempt de catalyseur, ledit dispositif comprenant :
- une chambre de dépôt ;
- des moyens pour créer une structure magnétique à miroir magnétique fortement déséquilibré dans ladite chambre de dépôt ;
- une zone de résonance cyclotron électronique à l'intérieur de ladite chambre de dépôt et faisant face audit substrat ;
- des moyens d'injection d'une puissance micro-ondes dans ladite chambre de dépôt ;
- des moyens pour créer une pression inférieure à 10⁻⁴ mbar d'un gaz contenant du carbone à l'intérieur de ladite chambre de dépôt.

16. Dispositif selon la revendication 15, comprenant, en outre, des moyens de chauffage du substrat.

17. Dispositif selon l'une quelconque des revendications 15 et 16 comprenant, en outre, des moyens de création d'une différence de potentiel entre le plasma et le substrat.

18. Couche, éventuellement sur un substrat, formée d'un tissu ou réseau de nanofibres ou nanotubes de carbone interconnectés comme dans une toile d'araignée, ladite couche étant exempte de catalyseur.

19. Couche selon la revendication 18, dans laquelle le carbone est de type graphite avec une proportion minoritaire de liaisons sp3 et une proportion majoritaire de liaisons sp2.

20. Couche selon l'une quelconque des revendications 18 et 19, dans laquelle le tissu ou réseau a une dimension moyenne de maille de une ou quelques dizaines de nm à une ou quelques centaines de nm, par exemple de 20 à 200 nm.

21. Couche selon l'une quelconque des revendications 18 à 20, dans laquelle le diamètre moyen des nanofibres ou des nanotubes est de un ou quelques nm à une ou quelques dizaines de nm, par exemple, de 1 à 100 nm.

22. Structure à plusieurs couches - ou structure multicouche - comprenant au moins deux couches de tissu de nanofibres ou nanotubes de carbone selon l'une quelconque des revendications 18 à 21.

23. Filtre comprenant au moins une couche selon l'une quelconque des revendications 18 à 21 ou au moins une structure multicouche selon la revendication 22, éventuellement sur un substrat.

24. Filtre selon la revendication 23, dans lequel ladite couche ou structure multicouche est étalée sur un grillage rigide à plus grandes mailles.

25. Nanogrille accélératrice ou décélératrice d'électrons comprenant au moins une couche selon l'une quelconque des revendications 18 à 21, ou au moins une structure multicouche selon la revendication 22.

26. Ecran plat, en particulier de grandes dimensions, comprenant une couche selon l'une quelconque des revendications 18 à 21, ou au moins une structure multicouche selon la revendication 22, éventuellement sur un substrat.

## Claims

1. Method for plasma deposition by electronic cyclotron resonance of a layer of a fabric made of carbon nanofibres or nanotubes, said layer being catalyst-free, on a catalyst-free substrate, by injection of a microwave power in a deposition chamber comprising a magnetic structure with a strongly unbalanced magnetic mirror, and at least one electronic cyclotron resonance zone inside said deposition chamber facing said substrate, whereby ionisation and/or dissociation of a gas containing carbon is provoked at a pressure of less than 10⁻⁴ mbar, in said magnetic mirror at the centre of the deposition chamber, thus producing species that will be deposited on said heated substrate.

2. Method according to claim 1, comprising the following steps:
- heating of the substrate,
- set up a pressure of less than or equal to 10⁻⁴ mbar, of a carbon containing gas,
- injection of the microwave power and creation of the plasma from said carbon containing gas, for a value of the magnetic field corresponding to the electronic cyclotron resonance,
- creation of a potential difference between the plasma and the substrate,
- dissociation and / or ionisation of molecules in said magnetic mirror at the centre of the deposition chamber,
- deposition of the formed species on said substrate to obtain a fabric of carbon nanofibres or nanotubes.

3. Method according to claim 2, in which the steps are carried out simultaneously.

4. Method according to any one of claims 1 to 3, in which the deposited carbon is of the graphite type with a minor proportion of sp3 links and a major proportion of sp2 links.

5. Method according to claim 1, in which said magnetic mirror structure is such that the magnetic field is maximum (Bₘₐₓ) at the microwave injection, then the magnetic field is minimum (Bₘᵢₙ) at the centre of the deposition chamber and finally the magnetic field rises up on the substrate (B_{substrate}).

6. Method according to claim 1, in which the mirror ratio "upflow", at the microwave injection, defined by r₁ = Bₘₐₓ (in Gauss)/Bₘᵢₙ (in Gauss) is more than 4.

7. Method according to any one of claims 1 to 6, in which the mirror ratio "downflow", towards the substrate, defined by r₂ = B_{substrate} (in Gauss)/Bₘᵢₙ is greater than or equal to 1.5.

8. Method according to any one of claims 1 to 7, in which the substrate is heated to a temperature of 500 to 750°C.

9. Method according to any one of claims 1 to 8, in which the pressure is less than or equal to 8 x 10⁻⁵ mbar.

10. Method according to one of claims 1 to 9, in which said carbon containing gas is chosen from among methane, ethane, ethylene, acetylene and mixtures thereof, to which hydrogen is possibly added.

11. Method according to claim 1, in which the substrate is heated by electronic bombardment or external heating.

12. Method according to claim 1, in which the microwave power is injected at a frequency of 2.45 GHz.

13. Method according to claim 1, in which the substrate is positively polarized, for example from +20 volts to +100 volts, and the plasma is earthed.

14. Method according to claim 1, in which the plasma is negatively polarized, for example from -20 volts to -100 volts, and the substrate is earthed.

15. Plasma deposition device by electronic cyclotron resonance (RCE) of layers of carbon nanofibre fabrics, said layers being catalyst-free, on a catalyst-free substrate, said device comprising:
- a deposition chamber,
- means of creating a magnetic structure with a strongly unbalanced magnetic mirror in said deposition chamber,
- an electronic cyclotron resonance zone inside said deposition chamber facing said substrate,
- means of injecting a microwave power into said deposition chamber,
- means of creating a pressure of less than 10⁻⁴ mbar of a carbon containing gas inside said deposition chamber.

16. Device according to claim 15, also comprising substrate heating means.

17. Device according to any one of claims 15 and 16, also comprising means of creating a potential difference between the plasma and the substrate.

18. Layer, possibly on a substrate, formed from a fabric or a network of carbon nanofibres or nanotubes interconnected as in a spider web, said layer being catalyst-free.

19. Layer according to claim 18, in which the carbon is of the graphite type with a minor proportion of sp3 links and a major proportion of sp2 links.

20. Layer according to any one of claims 18 and 19, in which the average mesh size of the fabric or network is ten or several tens of nm to a hundred or several hundreds of nm, for example from 20 to 200 nm.

21. Layer according to any one of claims 18 to 20, in which the average diameter of the nanofibres or the nanotubes is from one or several nm to ten or several tens of nm, for example from 1 to 100 nm.

22. Structure with several layers - or multilayer structure - comprising at least two carbon nanofibre or nanotube fabric layers according to any one of claims 18 to 21.

23. Filter comprising at least one layer according to any one of claims 18 to 21 or at least one multilayer structure according to claim 22, possibly on a substrate.

24. Filter according to claim 23, in which said layer or multilayer structure is spread on a rigid lattice with larger meshes.

25. Electron accelerating or decelerating nanogrid comprising at least one layer according to any one of claims 18 to 21, or at least one multilayer structure according to claim 22.

26. Flat screen, particularly of large dimensions, comprising a layer according to any one of claims 18 to 21, or at least one multilayer structure according to claim 22, possibly on a substrate.

## Patentansprüche

1. Verfahren zur Abscheidung einer Schicht aus einem Kohlenstoffnanofaser- oder -nanoröhrengewebe durch ein Elektronenzyklotronresonanzplasma, wobei die Schicht katalysatorfrei ist, auf ein katalysatorfreies Substrat durch Einspeisung einer Mikrowellenleistung in eine Abscheidungskammer, die eine magnetische Struktur mit einem in hohem Ungleichgewicht befindlichen magnetischen Spiegel und wenigstens eine Elektronenzyklotronresonanzzone im Inneren der Abscheidungskammer und gegenüber dem Substrat umfasst, wodurch unter einem Druck von weniger als 10⁻⁴ mbar die Ionisation und/oder Dissoziation eines Kohlenstoff enthaltenden Gases in dem magnetischen Spiegel in der Mitte der Abscheidungskammer bewirkt wird und so Spezies erzeugt werden, die sich auf dem Substrat, das erhitzt wird, abscheiden.

2. Verfahren gemäß Anspruch 1, das die folgenden Schritte umfasst:
- Erhitzen des Substrats,
- Aufbau eines Drucks unter oder gleich 10⁻⁴ mbar des Kohlenstoff enthaltenden Gases,
- Einspeisung der Mikrowellenleistung und Erzeugen des Plasmas aus dem Kohlenstoff enthaltenden Gas für einen Wert des Magnetfelds, der der Elektronenzyklotronresonanz entspricht,
- Herstellen einer Potentialdifferenz zwischen dem Plasma und dem Substrat,
- Dissoziation und/oder lonisation der Moleküle in dem magnetischen Spiegel in der Mitte der Abscheidungskammer,
- Abscheidung der gebildeten Spezies auf dem Substrat unter Erhalten eines Kohlenstoffnanofaser- oder -nanoröhrengewebes.

3. Verfahren gemäß Anspruch 2, wobei die Schritte gleichzeitig ausgeführt werden.

4. Verfahren gemäß einem der Ansprüche 1 bis 3, wobei der abgeschiedene Kohlenstoff vom Graphittyp mit einem geringeren Anteil von sp³-Bindungen und einem größeren Anteil sp²-Bindungen ist.

5. Verfahren gemäß Anspruch 1, wobei die Struktur des magnetischen Spiegels derart ist, dass das Magnetfeld bei der Mikrowelleneinspeisung ein Maximal (Bₘₐₓ) aufweist, das Magnetfeld in der Mitte der Abscheidungskammer dann ein Minimum (Bₘᵢₙ) aufweist und schließlich das Magnetfeld auf dem Substrat (B_{substrat}) wieder zunimmt.

6. Verfahren gemäß Anspruch 1, wobei das durch r₁ = Bₘₐₓ (in Gauß)/Bₘᵢₙ (in Gauß) definierte Spiegelverhältnis stromaufwärts der Mikrowelleneinspeisung höher als 4 ist.

7. Verfahren gemäß einem der Ansprüche 1 bis 6, wobei das durch r₂ = B_{substrat} (in Gauß)/Bₘᵢₙ definierte Spiegelverhältnis stromabwärts zum Substrat hin höher als oder gleich 1,5 ist.

8. Verfahren gemäß einem der Ansprüche 1 bis 7, wobei das Substrat auf eine Temperatur von 500 bis 750 °C erhitzt wird.

9. Verfahren gemäß einem der Ansprüche 1 bis 8, wobei der Druck niedriger als oder gleich 8.10⁻⁵ mbar ist.

10. Verfahren gemäß einem der Ansprüche 1 bis 9, wobei das Kohlenstoff enthaltende Gas aus Methan, Ethan, Ethylen, Acetylen und ihren Gemischen, gegebenenfalls mit Wasserstoff ausgewählt wird.

11. Verfahren gemäß Anspruch 1, wobei das Erhitzen des Substrats durch Elektronenbeschuss oder durch externes Erhitzen durchgeführt wird.

12. Verfahren gemäß Anspruch 1, wobei die Einspeisung der Mikrowellenleistung bei einer Frequenz von 2,45 GHz stattfindet.

13. Verfahren gemäß Anspruch 1, wobei das Substrat zum Beispiel von +20 Volt bis +100 Volt positiv polarisiert ist und das Plasma an Masse liegt.

14. Verfahren gemäß Anspruch 1, wobei das Plasma zum Beispiel von -20 Volt bis -100 Volt negativ polarisiert ist und das Substrat an Masse liegt.

15. Vorrichtung zur Abscheidung von Schichten aus einem Kohlenstoffnanofasergewebe durch ein Elektronenzyklotronresonanzplasma (EZR), wobei die Schichten katalysatorfrei sind, auf ein katalysatorfreies Substrat und die Vorrichtung
- eine Abscheidungskammer,
- Mittel zum Schaffen einer Struktur eines in hohem Ungleichgewicht befindlichen magnetischen Spiegels in der Abscheidungskammer,
- eine dem Substrat gegenüberliegende Elektronenzyklotronresonanzzone im Inneren der Abscheidungskammer,
- Mittel zur Einspeisung einer Mikrowellenleistung in die Abscheidungskammer und
- Mittel zum Schaffen eines Drucks unter 10⁻⁴ mbar eines Kohlenstoff enthaltenden Gases im Inneren der Abscheidungskammer umfasst.

16. Vorrichtung gemäß Anspruch 15, die außerdem Mittel zum Erhitzen des Substrats umfasst.

17. Vorrichtung gemäß einem der Ansprüche 15 und 16, die außerdem Mittel zum Herstellen einer Potentialdifferenz zwischen dem Plasma und Substrat umfassen.

18. Schicht, gegebenenfalls auf einem Substrat, die aus einem Gewebe oder Netz aus Kohlenstoffnanofasern oder -nanoröhren gebildet ist, die spinnwebartig miteinander verbunden sind, wobei die Schicht katalysatorfrei ist.

19. Schicht gemäß Anspruch 18, bei der der Kohlenstoff vom Graphittyp mit einem geringeren Anteil von sp³-Bindungen und einem größeren Anteil sp²-Bindungen ist.

20. Schicht gemäß einem der Ansprüche 18 und 19, bei der das Gewebe oder Netz eine mittlere Maschenweite von zehn oder einigen zehn nm bis einhundert oder einigen hundert nm, zum Beispiel von 20 bis 200 nm aufweist.

21. Schicht gemäß einem der Ansprüche 18 bis 20, bei der der mittlere Durchmesser der Nanofasern oder Nanoröhren von einem oder einigen nm bis zehn oder einigen zehn nm, zum Beispiel von 1 bis 100 nm beträgt.

22. Struktur mit mehreren Schichten - oder Mehrschichtstruktur -, die wenigstens zwei Kohlenstoffnanofaser- oder -nanoröhrenschichten gemäß einem der Ansprüche 18 bis 21 umfasst.

23. Filter umfassend wenigstens eine Schicht gemäß einem der Ansprüche 18 bis 21 oder mindestens eine Mehrschichtstruktur gemäß Anspruch 22, gegebenenfalls auf einem Substrat.

24. Filter gemäß Anspruch 23, bei dem die Schicht oder Mehrschichtstruktur auf einem starren Gitterwerk mit größerer Maschenweite aufgetragen ist.

25. Elektronenbeschleunigendes oder -verzögerndes Nanogitter, das wenigstens eine Schicht gemäß einem der Ansprüche 18 bis 21 oder wenigstens eine Mehrschichtstruktur gemäß Anspruch 22 umfasst.

26. Flachbildschirm, insbesondere mit großen Abmessungen, der eine Schicht gemäß einem der Ansprüche 18 bis 21 oder wenigstens eine Mehrschichtstruktur gemäß Anspruch 22, gegebenenfalls auf einem Substrat umfasst.
